# EUROPEAN PATENT APPLICATION

(11) **EP 3 367 528 A1**
(43) Date of publication of application: **29.08.2018**
(21) Application number: 18157241.3
(22) Date of filing: 16.02.2018
(51) Int. Cl.: H02H 3/04, G01R 31/08, H02H 7/26, H02J 13/00

(54) **LOCALIZED APPLICATION OF HIGH IMPEDANCE FAULT ISOLATION IN MULTI-TAP ELECTRICAL POWER DISTRIBUTION SYSTEM**

(30) Priority: 16.02.2017 US 201715435002
(71) Applicant: Electrical Materials Company, Genoa City, Wisconsin 53128 (US)
(72) Inventor: O'REGAN, Timothy M., Chicago, IL 60631 (US); O'REGAN, Timothy J., Park Ridge, IL 60068 (US); HAYES, Thomas M., Highlands Ranch, CO 80126-5629 (US)
(74) Representative: Carpmael, Robert Maurice Charles

(57) **Abstract**

A high impedance fault isolation system (HIFIS) identifies, isolates and dissipates high impedance, low current faults which occur within an individual tap, or branch, of an electric power distribution system using only portions of the tap affected. A master meter, or father smart meter (FSM), on the affected tap sends a coded signal to an antenna receiver combined with a microprocessor and chip (420) which operates an electromagnetic control (EMC) grounding spring (409) switch which isolates the downed primary conductor by causing the distribution system protecting device (334), i.e., a high voltage fuse or recloser, to de-energize the downed primary wire. This localized application of the HIFIS at the individual tap level allows the FSM to analyze and determine, for example, that the specific field condition is a "downstream wire down", and that the installed isolating device has failed to operate because of insufficient fault current, allowing the localized intervention of the HIFIS to achieve the de-energization more efficiently and safely, and within a much shorter time period. A fire door sensor circuit then receives the trip signal from the microprocessor, causing the fire door sensor to melt open and release a shorting spring, in initiating operation of an expulsion fuse or recloser, which kills the downed live wire.

Fig. 3

## Description

### FIELD OF THE INVENTION

This invention relates generally to apparatus for sensing, isolating and de-energizing a downed alternating current electric utility primary distribution circuit conductor which has developed into a high impedance fault which overcurrent protection devices or high impedance detection systems have been unable to clear. This dangerous condition may occur at any location on an electrical utility distribution circuit due to lack of conductivity of the earth in the fault current return path. In some instances, the line impedance due to the distance of the ground fault from the substation source combined with high fault impedance at the wire down location may limit the ground fault current to a value less than the normal actual load current at this location. There is a need for a fault isolating package that has no limitation on distance limits or fault current value.

A type of high impedance fault condition may also occur when a high voltage primary conductor is downed, poorly grounded and the primary conductor is back fed through a wye-delta secondary 3 phase power bank providing a dangerous high voltage condition, yet insignificant fault current. In this latter situation, the delta connected windings of three single phase transformer windings of different phases provide an induced transformed source of a low level back fed fault current and a dangerous high voltage condition on the downed primary conductor.

The frequent occurrence of live downed high voltage primary conductors is directly related to the high incidence of variable high impedance ground fault return paths. This variable ground fault impedance is directly related to the various withstand voltages of a wide range of values of impedances in the variable grounding material. The withstand voltage, measured in volts per inch across the material under stress, may vary over a period of time as high voltage is maintained at the fault by the downed wire. This variation in the material withstand voltage is dependent upon both material type and its moisture content. A breakdown by the line to ground fault voltage of the earth material into carbon paths, which is leakage fault current seeking return paths to the power source, is one impedance progression which occurs until the high impedance ground resistance collapses and the full available fault current occurs. Carbon paths may develop, either directly through the material or via a circuitous exterior path. A poorly developed carbon path may also result in re-establishing a high impedance because the downed conductor can move (dance) as the fault current begins to flow, landing on another highly non-conducive medium, permitting the downed high voltage live wire condition to persist with high impedance to ground.

The present invention, more specifically, is directed to an electrical safety device capable of detection, processing and isolating a high impedance, low fault current disposed in the main circuit or in a remote branch, or tap, of an electrical power distribution circuit. This inventive fault elimination arrangement employs only those components within the faulted section, and does not impact the overall control and/or operation of the electrical power distribution protection system. In addition, surge arrestors are connected to a driven ground located on the same pole as the arrestors, with ground rod resistance limited to no more than 5 ohms on the distribution system per National Safety Code requirements.

### BACKGROUND OF THE INVENTION

High impedance, low current faults, such as a downed distribution line conductor in an electric utility distribution network which is contacting a poor conductive earth composite, have proven to be difficult to isolate with present technology. Conventional overcurrent protection devices, both at the source and at strategic circuit locations, use the combined relationship of fault current magnitude and time duration to clear faults associated with downed grounded high voltage conductors. A particularly difficult situation for detecting a high impedance fault in an electrical distribution system incorporating a live conductor downed, but intact, where the conductor is grounded through a poor conducting medium such as sand, rock, concrete, snow, blacktop or a dead tree. The variable ground fault impedance may approach infinity with an equivalent fault current value of zero amps

For reliability purposes, it is common electric utility practice to install downstream circuit reclosers, expulsion fuses or sectionalizers at all taps to the main stem distribution circuit. These protection devices function to locally isolate faulted circuit portions in the smallest segments possible, in order to maintain normal service to the balance of customers on that same circuit. These downstream overcurrent protection devices are designed to be time coordinated with each other and with the main circuit breaker in order to automatically isolate dangerous conditions located throughout the distribution circuit.

Present applied overcurrent protection devices are, however, unable to distinguish low fault currents (high impedance faults) from normal load currents because trip settings for these devices are typically set at 125 to 250 per cent of maximum estimated peak load current. These standard tripping current levels are selected to minimize inadvertent tripping due to transient causes. Isolating devices with more sensitive protection have recently been introduced, but still require a certain minimum value of fault current and have no automated means of clearing for a zero current flow. A hazardous condition for the public is created when energized high voltage conductors fall to the ground or come in contact with a high impedance fault current return path, and the overcurrent protection system fails to de-energize the conductor. Physical contact with an energized distribution primary conductor by any conducting body may cause serious injury or death due to electric shock. Numerous fatalities and serious injuries occur annually in the United States due to inadvertent contact with live down power distribution conductors. Experience has shown that these conditions occur more frequently at distribution level voltages of 15KV and below, which is the predominant primary distribution voltage range in the United States. The current National Electrical Safety Code limits the maximum allowed ground rod resistance to 5 ohms or less when measured with a ground resistance meg to multi-ground requirements for electrical distribution.

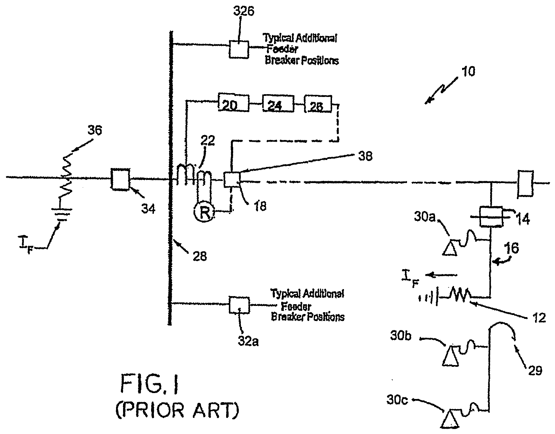

Referring to FIG. 1, there is shown a simplified schematic diagram of a prior art high impedance fault sensing arrangement. An overhead distribution primary circuit 10 includes a substation bus 28 which is energized by a substation step down transformer 36 which is connected to the substation bus via a substation bus transformer breaker 34. Coupled to and extending from the substation bus 28 are plural branch tap circuits, each coupled to the substation bus by means of a respective distribution feeder breaker. Thus, two distribution feeder breakers are shown in FIG. 1 as elements 32a and 32b, with a third main overcurrent relay-circuit breaker combination shown as element 18 in the figure. The overhead distribution primary circuit 10 is subject to the occurrence of a low current, high impedance fault 12 on a branch tap 16 which is not detectable by a circuit recloser 14 or by the main overcurrent relay-circuit breaker combination 18. Branch tap 16, which is similar to other branch taps connected to distribution feeder breakers 32a and 32b, also includes plural distribution transformers 30a, 30b and 30c, and is shown experiencing the low current, high impedance fault 12, such as broken or downed conductor 29. A high impedance detection arrangement 20 coupled to the overhead distribution primary circuit 10 by means of a transducer 22 receives generated signals through the transducer. These signals are conditioned and compared by a microprocessor 24 with a stored signal pattern which is characteristic of normal system operation. A microcomputer 26 coupled to the microprocessor 24 as well as to the main overcurrent relay-circuit breaker combination 18 makes a trip/output decision based upon several operating parameters which are weighted. While the arrangement shown in FIG. 1 is designed for detection and shutdown of high voltage (low impedance) faults involving large currents, it is incapable of detecting and isolating high voltage ground faults accompanied by minimal ground fault currents due to variable high impedance faults. A low fault current isolator system is needed to permit electrical utilities to detect a high impedance fault characterized by a zero, or very low, value of ground fault current, to minimize the time period that a downed wire remains alive, after an overcurrent protection fault isolation device has failed to de-energize the downed live high voltage wire.

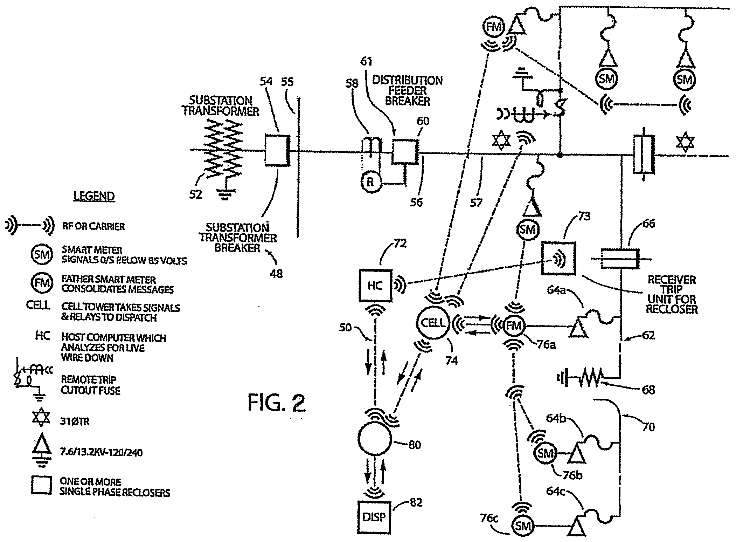

The invention disclosed and claimed in U.S. Patent No. 9,136,692 (hereinafter "the '692 patent") overcomes the aforementioned limitations of the prior art by sensing the combination of loss of voltage on the load side of a downed conductor and comparing it with live voltage on the source side of the same downed wire. Applicant's U.S. Patent No. 9,385,522, which was filed as a divisional application based upon the '692 patent, is also involved with a downed wire in an electrical power distribution system. The disclosure and claims of the '692 patent are hereby incorporated in the present application by reference. This downed wire constitutes a very high impedance fault characterized by a limited fault current typically below the tripping value of the associated fault isolating device. The detection, isolation and de-energization of the downed or damaged live conductor is analyzed and controlled by a host computer through remote tripping of an associated isolation device. This process functions automatically and serves as a backup to a conventional overcurrent protection system for de-energizing high impedance electrical distribution primary faults, while permitting normal service to continue on the unaffected remainder of the power distribution circuit. As shown in Fig. 2, this approach stores a change in voltage status if the change in status continues beyond five (5) seconds, and an indication of the loss of voltage is transmitted by an internal slave smart meter modem to a father smart meter 76a over a communication link via the combination of a cell tower 74 and server/sorter 80, with the host computer 72 making a decision in accordance with a live wire downed analysis program stored in the host computer. Thus, the detection, isolation and elimination of a high impedance fault 68 within branch tap 62 requires accessing and coordinating the operation of the host computer 72, the cell tower 74, the server/sorter 80 and the work dispatcher 82 to complete the isolation and clear the downed primary live wire.

The present invention addresses this complex and expensive approach to detecting, isolating and eliminating a high impedance fault in a branch tap 62 of an overhead distribution primary circuit 56 by localizing both the polling of both SM'S ("out of service signals" and "in service signals"), plus analyzing the coded signals with proprietary software and subsequently applying a bolted ground fault on the isolating device. The electrical equivalent circuit of this operation is paralleling a bolted phase to ground minimal impedance with the high impedance downed wire conductor, resulting in increased fault current to trip the isolating device. The present invention also addresses this approach with a locally installed compound device which monitors out of service slave smart meter RF signals and if a downed wire condition is analyzed, applies a bolted ground fault to the same primary fault isolator which was unable sense and clear the high impedance fault downed wire condition due to a fault current value less than the sensing value. Accordingly, there is a need for quickly and safely detecting, isolating and clearing of a high impedance fault such as a downed electric utility high voltage primary distribution circuit conductor using a low cost, locally controlled spring-loaded earth grounding device to operate the primary tap isolating device.

### OBJECTS AND SUMMARY OF THE INVENTION

Accordingly, it is an object of the present invention to minimize (out of service) signal data processing time and safely detect, isolate and de-energize an AC electric utility primary distribution circuit conductor in a multi-tap, or multi-branch, electric power distribution network using only the effected tap, or branch, for isolation and protection of the power distribution network without involving other standard portions of the distribution network's fault analysis and isolation package.

It is another object of the present invention to provide for the automatic detection, isolation and shutdown of a high impedance, low fault current in a high voltage electrical power distribution network comprised of plural independent and separate branches, or taps, using only the circuitry of the faulted branch, or tap, and not any portion of the non-faulted branches or of the electric power distribution circuit itself, to minimize SM out of service (O/S) signal data handling, to more efficiently, faster, more simply and safely automatically detect, isolate and shutdown the high impedance, low fault current in the effected high voltage tap.

It is a further object of the present invention to locally detect, isolate and shutdown a high impedance, low fault current which occurs in a remote branch, or tap, of a multi-branch electric power distribution network which remains undetected by an automated overcurrent isolating device.

A still further object of the present invention is to detect, isolate and neutralize a high impedance, low current fault in one of plural branches, or taps, of a plural branch electric power distribution network by directly accessing and isolating the downed high voltage conductor, and neutralizing the fault without involving other distribution system components not directly involved with the faulted conductor.

The present invention contemplates an arrangement in an electrical distribution system for identifying, isolating and clearing a live high voltage wire down in any one of plural feeder taps, the arrangement comprised of one or more father smart meters (FSM) disposed in each of the taps and coupled to each of plural slave smart meters in a respective one of said taps, wherein each of said one or more FSM's is adapted to (1) receive downstream loss of voltage signals and in service coded signals from each of the other master and or slave smart meters to which the FSM is coupled, and (2) and form a HIFIS (High Impedance Fault Isolation System) polling and logging with an RF LAN antenna and receiver and logging the coded slave SM in service or (out of service) signals, for analysis by the microprocessor combined with a compliant IEEE STANDARD 802.16 chip. Positive analysis of the coded signal data associated with a downed wire by the above mentioned chip, results in the microprocessor closing a normally open relay contact in the fire door sensor electrical circuit, which applies 120 volts to melt the fire door sensor releasing a coiled earth grounded spring; and the grounded spring applies earth ground to the load side of a high voltage distribution system isolator (expulsion fuse, recloser or sectionalizer) which clears the fault and deenergizes the live primary downed wire.

### BRIEF DESCRIPTION OF THE DRAWINGS

The appended claims set forth those novel features which characterize the invention. However, the invention itself, as well as further objects and advantages thereof, will best be understood by reference to the following detailed description of a preferred embodiment taken in conjunction with the accompanying drawings, where like reference characters identify like elements throughout the various figures, in which:
Fig. 1 is simplified combined block and schematic diagram of a prior art high voltage fault sensing arrangement such as for use in an electric power distribution network;
Fig. 2 is a simplified schematic diagram of a portion of a typical electric power distribution system incorporating a prior art arrangement for isolating high impedance faults;
Fig. 3 is a simplified schematic diagram illustrating details of a high impedance, low fault current downed wire detection, isolation and de-energization system (HIFIS) in accordance with the principles of the present invention;
Fig. 4 is a simplified schematic and block diagram illustrating a tripping circuit for safely grounding a faulted primary tap incorporating a fuse in accordance with one embodiment of the present invention;
Fig. 5 is a simplified schematic and block diagram illustrating a tripping circuit for safely grounding a faulted primary tap incorporating a recloser in accordance with another embodiment of the present invention;
Fig. 6A, 6B and 6C are logic flow diagrams illustrating the various operations carried out by the HIFIS during detection, localization and de-energization of a high impedance, low current fault in a high voltage tap of an electrical power distribution system in accordance with the present invention; and
Fig. 7 is a circuit schematic illustrating the flow of backfed electric current within an electric power distribution network incorporating coupled multi-phase power distribution transformers, where the backfed electric current is due to a high impedance fault in the primary, or source, side of the delta connected secondary connection. This control circuit must operate all grounded springs to insure no backfed situations exist on the downstream circuit.

### DETAILED DESCRIPTION OF THE PREFERRED EMBODIMENTS

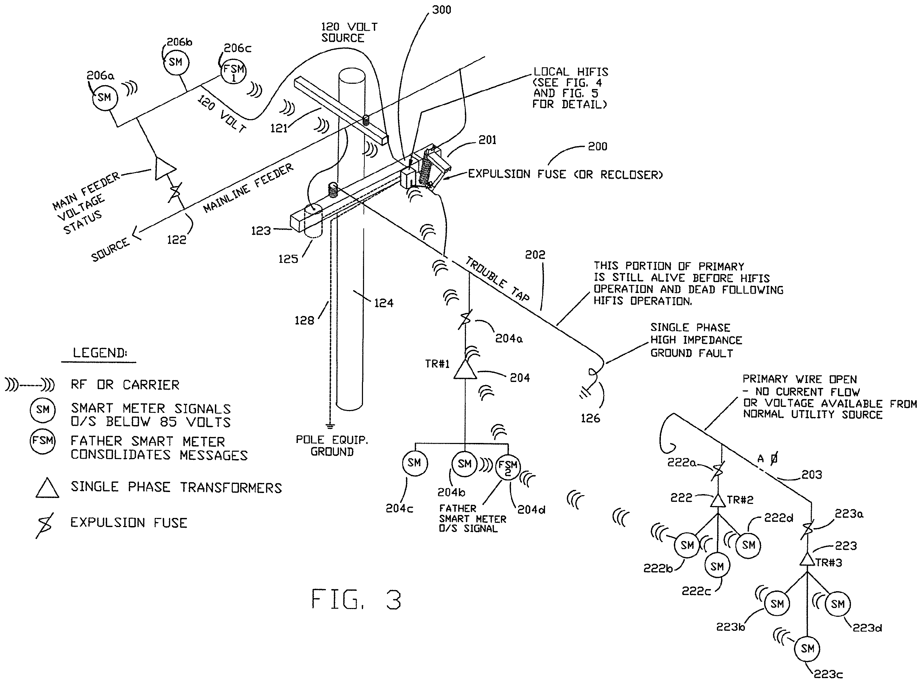

Referring to Fig. 3, there is shown in simplified schematic diagram form the involved components on a single phase utility overhead distribution circuit tap 200 which is adapted to clear a live wire down fault in accordance with one embodiment of the present invention. Single phase tap 200 includes a mainline feeder 122 carrying electrical energy from a power source (not shown in the figure). Mainline feeder 122 is coupled to and supported by an electric pole 124 having an attached first cross member 121.

Attached to a second cross member 123 on the electric pole 124 is a primary tap fuse isolator 201 and a trouble primary tap 202 which was previously formed with and attached to a now broken primary wire 203 which includes a high impedance fault 126. Trouble primary tap 202 represents a portion of the primary tap which is still electrically alive. Attached to the trouble portion of the primary tap 202 is a serially coupled combination of a first transformer 204 and a first fuse 204a. The combination of the first transformer 204 and first fuse 204a is also coupled to the radial arrangement of a first smart meter (SM) 204a, a second smart meter (SM) 204b, and a father (master) smart meter (FSM) 204d.

The distal end of the primary tap, or open wire, 203 is electrically dead and no longer carries electric current sourced by its normal primary circuit. Primary open wire 203 is illustrated disconnected from trouble primary wire, or tap, 202 and is attached to second and third combinations of a second transformer 222 and a second fuse 222a and a third transformer 223 and a third fuse 223a which are coupled in parallel respectively to fourth through sixth smart meters (SM's) 222b, 222c and 222d and to seventh through ninth smart meters 223b, 223c and 223d (SM's).

In this arrangement, FSM 204d receives out of service (O/S) signals from all of the aforementioned SM's plus live voltage status signals from SM'S 204a and 204b. HIFIS 300 is associated with a fuse or recloser 201 which is positioned on the second cross member 123 attached to the electric pole 124. HIFIS 300 is equipped with a Local Area Network (LAN) antenna receiver which polls the incoming voltage signals from SM 222 and analyzes the data using an IEEE STANDARD 802.16 compliant chip as described below.

The electrical pole's second cross member 123 also supports the lead 126 to a 120 volt source and an earth grounded connection lead 128 (shown in dotted line form), both connected to the HIFIS 300 pole-mounted monitor with a ground resistance of no more than 5 ohms. Having referenced all of the external connections and the source of the coded signal data, the operation of the single phase utility overhead distribution circuit tap 200 and associated High Impedance Fault Isolation System (HIFIS) 300 will now be described. The pole mounted HIFIS 300 case contains the LAN antenna with receiver, polling the associated SM coded signals of both o/s and in service data to the main tap FSM 204d.

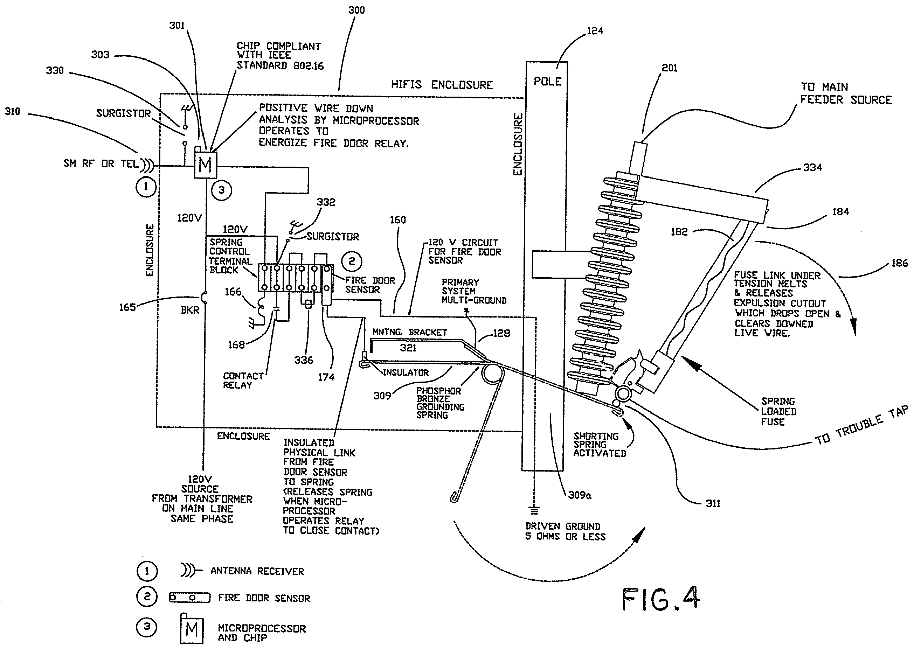

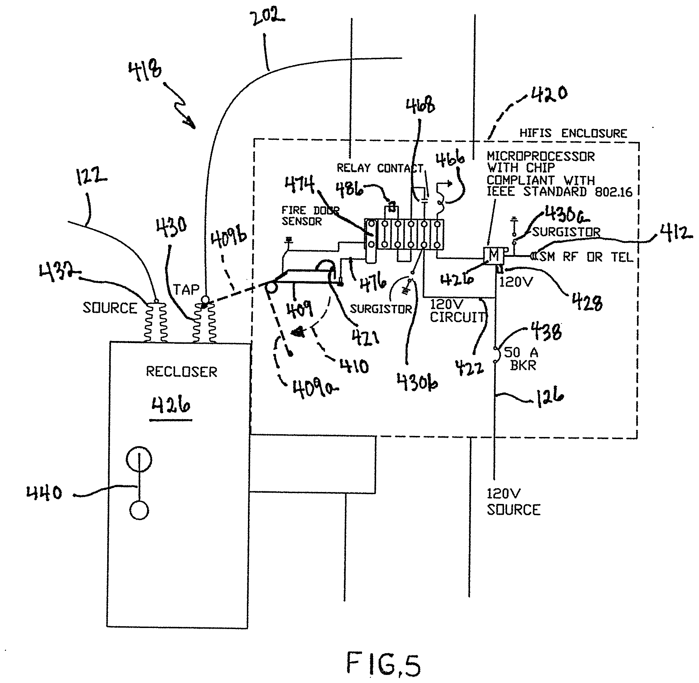

Referring to Fig. 4, there is shown in schematic and block diagram form a tripping circuit 160 for grounding the trouble primary tap 202. A 120 volt source coupled to the High Impedance Fault Isolation System is a multi-tapped potential transformer encased in the primary bushing mounted on the HIFIS cabinet protected by a metal oxide arrestor mounted adjacent to the potential transformer. The HIFIS 300 microprocessor 301 stores coded signal data from antenna 310 for data storage and subsequent analysis by the IEEE STANDARD 802.16 compliant chip 303 shown in Fig. 4. A positive wire down determination by the chip 303 initiates an energizing relay coil 166 for closing contact 168 to apply the 120 volt circuit to melt a fire door sensor 174 and release a solidly grounded phosphor bronze spring 309. The phosphor bronze spring 309 is released from its temporary position on a stainless steel holder 321 for applying a single phase ground fault to the primary tap's isolator bronze rod 311 directing the former high impedance fault to a solid ground 312. More specifically, the stainless steel holder 321 releases from its temporary position the phosphor bronze spring 309 shown in solid lines, to a second position illustrated in dotted line form as the activated solidly grounded spring 309a, which applies a bolted fault to ground 312 to activate the isolation device, which is a high voltage fuse or recloser. The 120 volt circuit further includes a circuit breaker 314 to provide over current protection for the HIFIS package 300. Lightning over voltage surge protection is provided by surge protectors 330 and 332. To insure clearing of the isolator, an adequate size earth ground conductor 128 shown in Fig. 3 is provided from the phosphor bronze spring 309 to earth ground, with a ground resistance of no more than 5 ohms. The phosphor bronze spring 309 is activated for engaging and grounding a local high voltage isolation device 334, which in the present case is in the form of cylindrical fuse holder 184, holding a tensioned live fuse link 182 disposed within the movable fuse holder, whereupon the tensioned fuse link melts and the fuse holder falls open under the influence of gravity in the direction of arrow 186. Melting of the fuse link 182 is coincident with downward movement of the fuse holder 184 and de-energizing of the downed live wire 202 as shown in Fig. 3. An inductor 336 is inserted in the circuit 160 to restrict the magnitude of the current melting the fire door sensor 174. The 120 volt fire door sensor melting circuit consists of a circuit breaker 165 and relay coil 166 and is coupled to its associated contact 168 which applies 120 volts to the current limiting inductor 336 which is coupled to earth ground and to stainless steel bracket 321. This brief description of this portion of the operation of the HIFIS 300 is equally applicable to the operation of a second embodiment of the invention involving a recloser 426 illustrated in Fig. 5 and described in detail below.

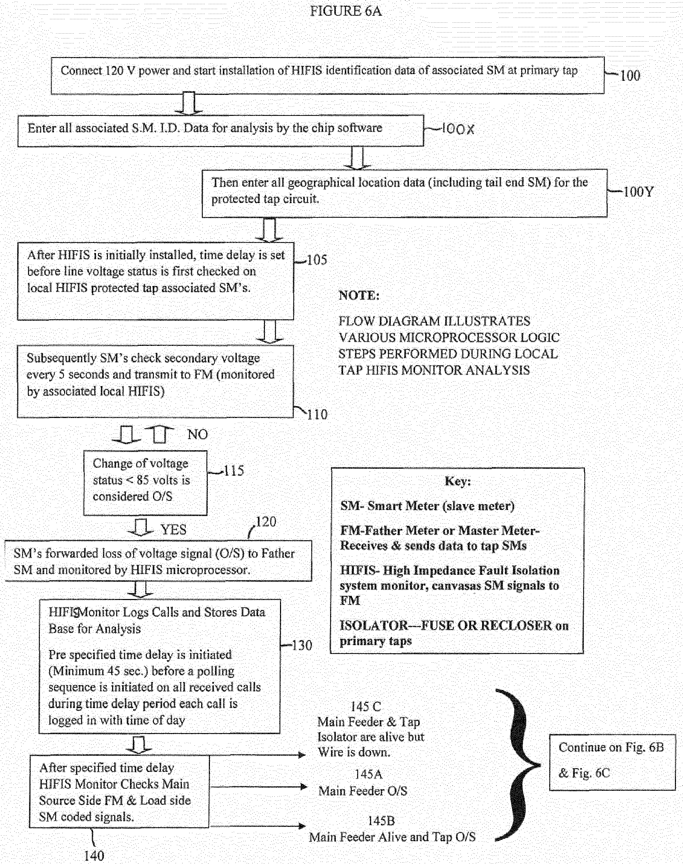

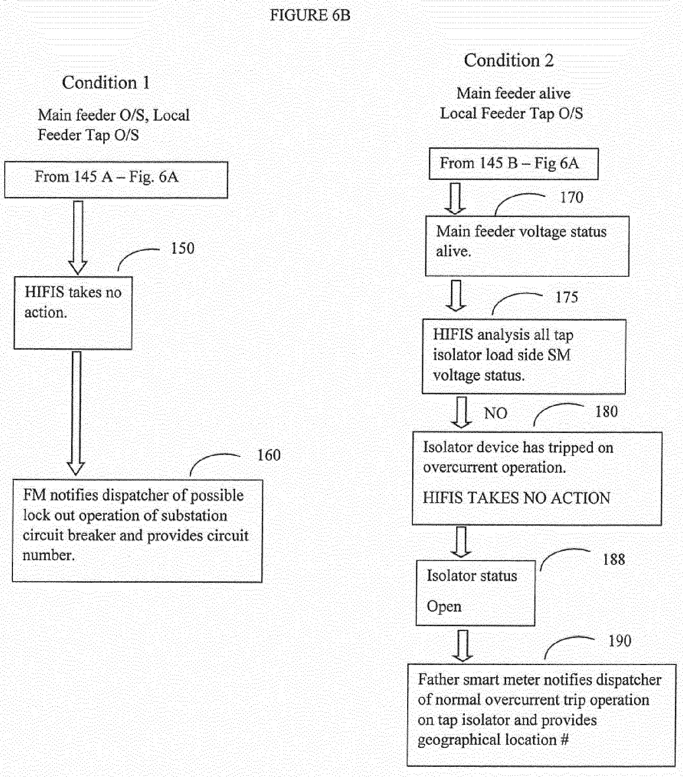

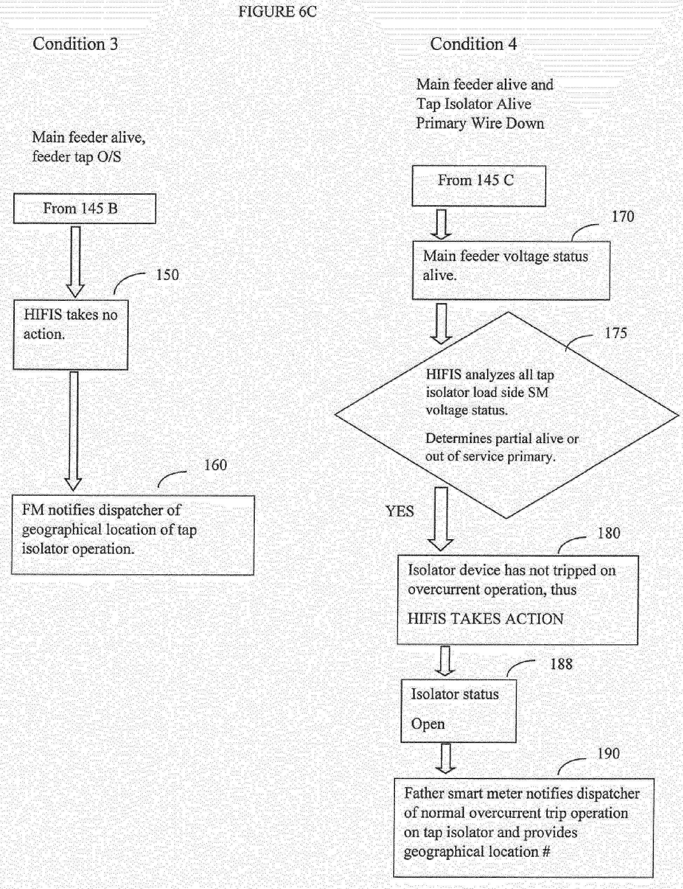

Referring to Fig. 5, there is shown the inventive high impedance fault detection and isolation arrangement, or tripping circuit, 418 incorporating a recloser 426 in accordance with another embodiment of the present invention. As in the previously described embodiment, the tripping circuit 418 includes a HIFIS 420 having the combination of a microprocessor 426 and a software chip 428. Microprocessor 426 stores coded signal data received and provided by an RF antenna or telephone line 412 for analysis by the chip 428. As in the previously described embodiment, the operation of microprocessor 426 is controlled by the software chip 428, with its operation also described in detail below in terms of Figs. 6A, 6B and 6C. Microprocessor 426 is also coupled to a 120 volt source lead 126 which incorporates a circuit breaker 438. The programmed output of the microprocessor 426 and chip 428 is provided to a relay sensor 466 which closes contact 468 and melts fire door sensor 474. Surgistors, or surge protectors, 430A and 430B are respectively coupled to the input of microprocessor 426 and to the 120 volt input to the fire door sensor 474. The fire door sensor 474 is coupled by an insulated cable tie 476 across the combination of a fixed stainless steel bracket 421 and the free end of a phosphor bronze spring 409, with the other end of the spring pivotally coupled to an end of the stainless steel bracket. The spring 409 falls under the influence of gravity in the direction of arrow 410 first to an intermediate position shown at 409a and then to a final position shown at 409B. With the phosphor bronze spring shown in position 409B, it is in contact with a first bushing terminal 430 of the recloser 426. The first brushing terminal 430 is coupled to the trouble primary tap 202 through the recloser 421, while a second bushing terminal 432 of the recloser 426 is coupled to the mainline feeder 122 connected to the source of electrical power. The application of the phosphor bronze spring 409 applying earth ground to the load side of the recloser 426 ensures that earth ground is maintained until recloser operation progresses through its routine reclosing operation to final lockout which necessitates a visit by a trouble crew for restoration of service. Upon arrival of the trouble crew, the recloser's manual lockout handle 440 will be in the locked open position. This confirms from ground level that recloser 426 has deenergized the downed conductor.

Referring to Figs. 6A, 6B and 6C, there is shown a computer chip program flow chart illustrating the sequence of software operations carried out under the control of the embedded software in microchip 303 in Fig. 4 and microchip 428 in Fig. 5 which are compliant per IEEE Standard 802.16.

The process starts at step 100 upon connection of the high impedance fault isolation system (HIFIS) to a source of 120 volt power for initiating installation of the high impedance fault isolation system at the primary tap. At step 110X, the HIFIS is energized to accept entry of all associated smart meter (SM) identification data required for processing of the chip in microprocessor 301. All of the associated data for the incorporated smart meters is then entered for analysis by the computer chip software at step 100X. In step 100Y, geographical location data for all of the aforementioned smart meters is then entered for the protected tap circuit, including the SM at the distal end of the primary tap. After initial installation of the HIFIS, a time delay is entered at step 105 before line voltage status is first checked on the local HIFIS protected tap associated SM's. The program then at step 110 every five seconds checks the secondary voltage of each SM and transmits this data to the father smart meter (FSM) 204d which is monitored by the associated local HIFIS. With a voltage level of 85 volts established as an out of service voltage (O/S), the program at step 115 then checks for a change in the secondary voltage value. If at step 115, it is determined that there has not been a change of voltage to a value less than 85 volts, the program returns to step 110 and continues every five seconds to check if there has been a change in secondary voltage value to a value less than 85 volts. If at step 115 a change of secondary voltage to a value less than 85 volts is detected, the program proceeds to step 120 where the SM which detected a loss of voltage provides a loss of voltage signal (O/S) to the FSM 204d which is logged in and stored by the HIFIS microprocessor. The program then proceeds to step 130 where this loss of voltage data is stored for analysis by the software chip 303. Also at this step, a pre-specified time delay of 45 seconds minimum is initiated before an analysis is initiated on each received SM O/S signal. During this time delay period, all SM O/S signals are logged in with the time of day. After the passage of the aforementioned pre-specified time delay, the HIFIS monitor checks the main source side FM 206c shown in Fig. 3 and the load side SM coded signals (both "in service" and "O/S"). This procedure allows for the detection of (1) a partial circuit voltage outage; (2) an entire circuit voltage outage; or (3) a live wire down as determined by the following sequence of steps described below.

If at step 140 the HIFIS monitor determines that the main feeder has an entire circuit outage, the program proceeds to step 145A and then to step 150, whereupon the HIFIS takes no further action. The program then proceeds to step 160 where the FM notifies the dispatcher of possible operation of the substation circuit breaker and provides the circuit number indicating the location of the affected substation circuit breaker.

If at step 140, the HIFIS monitor determines that the main feeder SM 206c is alive and that only the tap is out of service, the program proceeds to step 170 for confirming that the main feeder is alive. The program then proceeds to step 175 where the HIFIS analyzes the status of all tap isolator load side SM voltages. If at step 180, the HIFIS determines that an isolator device has tripped an over current operation, the HIFIS takes no action. The program then proceeds to step 188 and leaves the isolator status open. The program then proceeds to step 190 where the FMS notifies the dispatcher of normal overcurrent trip operation on the tap isolator and provides the geographical location number of the affected circuit. The operating program, or embedded software, within HIFIS chip 303 then proceeds to step 145c with reference to Fig. 6c where the main feeder is determined to be alive and a tap is determined to be out of service such as where a primary wire is down, followed by the HIFIS taking no action. Isolator status remains open at step 188, followed by the FSM notifying the dispatcher of normal overcurrent trip operation on the tap isolator and the geographic location of the SM's affected at step 190.

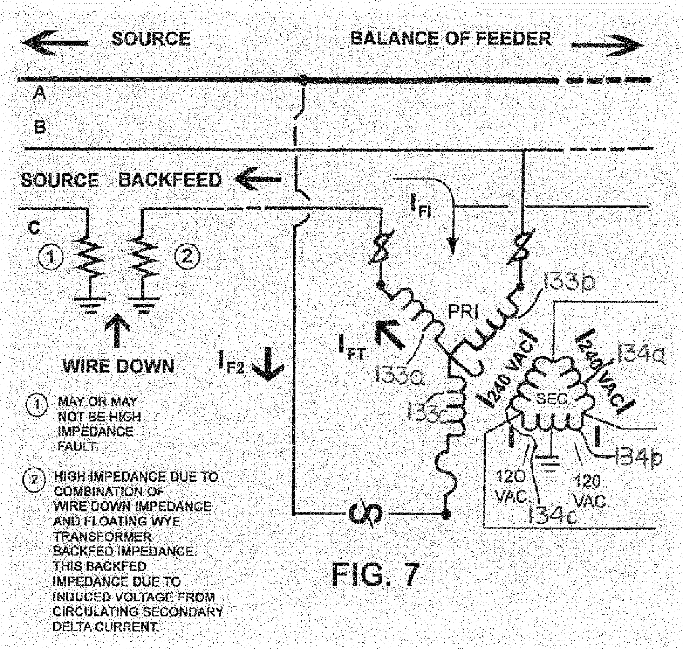

With reference to Fig. 7, there is shown a simplified circuit schematic diagram illustrating the manner in which high voltage is backfed from a common connection of the three single phase transformer arrangement, where the three primary windings of the transformers are respectively identified as elements 133a, 133b and 133c which are disposed in the shape of a "Y" in the figure for simplicity. Each of the three primary windings 133a, 133b and 133c (illustrated in a "WYE" shape) is electromagnetically coupled to a respective one of secondary windings 134a, 134b and 134c connected in a delta arrangement in the three transformer connection arrangement. In this arrangement, while one phase may be deenergized from the substation source, the two remaining energized phases provide a backfed voltage to neutral ground. Thus, voltages from the two hot legs 133b and 133c of the three coupled transformers carry a circulating current in secondary windings 134b and 134c, respectively. A fault current TFT, where In+IF2=IFT, is produced in the primary grounded winding 134a and is directed as a high impedance fault to neutral ground potential via high impedance ground line 138 coupled to secondary winding 134a. Three primary winding connections, each coupled to a secondary winding of a respective one of the three transformers, are tied to a common point A in each transformer which is connected to a floating neutral potential 139. Circulating current in the low side delta connection is transformed to the high side winding phase faulted to ground. The transformers increase the impedance due to backfeed.

Fig. 7 also illustrates the manner in which a downed primary high voltage phase conductor is back fed via high voltage, through a three single phase distribution transformer arrangement connected open wye-delta. This standard transformer connection is used in three phase power installations, with a connected floating primary wye-delta (secondary delta is 120/240 volt single phase; 3 phase, 4 wire, 240 volt; or 3 phase, 240 volt). Specifically, when a primary wire is downed which is source connected to one of the primary transformer wye connected windings, the fault is backfed via the other two wye-delta connected windings. This backfed primary phase conductor now is the source for this high voltage, high impedance dangerous live wire downed condition. Each of the three single phase primary windings 133a, 133b, 133c (illustrated in a floating WYE connection) is electromagnetically coupled to respective secondary connected winding 134a, 134b or 134c which are connected in a delta three phase transformer connection arrangement. The downed single phase primary conductor is one of the three phase conductors connected to the normal substation source, serving the power wye-delta connected transformer bank. The source fed downed earth grounded primary conductor may have a low value local earth impedance, which permits the normal source side isolator to clear the source side downed primary. However, the formerly downstream connected primary conductor can be energized from the two remaining energized phases which provide a transformed induced backfed high voltage via a high impedance transformer winding. The current circulating via electromagnetism in the transformer delta secondary winding connection transforms a dangerous primary level voltage with a very low current value - this troubled wye-delta transformer is, in effect, a variable high impedance, high voltage lethal source - which endures until the wye-delta transformer primary source is completely isolated on all phases.

The present invention therefore provides an arrangement [200] for identifying, isolating and clearing, or a identifying, isolating and clearing arrangement, system or device for identifying, isolating and clearing, a live wire down fault in any one of plural feeder taps within the electrical distribution system, wherein said live wire down fault is characterized by a high impedance and a low or zero currentFor use in an electrical power distribution system having a ground rod resistance limited to 5 ohms or less, and/or a circuit for detecting, isolating and de-energizing a downed conductor in an electric utility distribution network, each or either as defined above, or in the appended claims.

While particular embodiments of the present invention have been shown and described, it will be obvious to those skilled in the relevant arts that changes and modifications may be made without departing from the invention in its broader aspects. Therefore, the aim in the appended claims is to cover all such changes and modifications that fall within the true spirit and scope of the invention. The matters set forth in the foregoing description and accompanying drawings are offered by way of illustration only and not as a limitation. The actual scope of the invention is intended to be defined in the following claims when viewed in their proper perspective based on the prior art.

## Claims

1. an arrangement [200] for use in an electrical power distribution system having a ground rod resistance limited to 5 ohms or less, for identifying, isolating and clearing a live wire down fault in any one of plural feeder taps within the electrical distribution system, wherein said live wire down fault is **characterized by** a high impedance and a low or zero current, said arrangement comprising:
plural slave smart meters [204a, 204b] disposed in a spaced manner throughout each of said feeder taps, wherein each of said slave smart meters [204a, 204b] is responsive to a loss in voltage in a primary tap [202] located in the vicinity of one of said smart meters;
a father smart meter [204d] disposed in each of said taps and responsive to a low or no voltage signal output by one or more of said slave smart meters [204a, 204b] in the father smart meter's associated tap; and
a tripping circuit [160, 418] disposed in each of said taps and responsive to a low or no voltage signal output received from a slave smart meter [204a, 204b] in the tripping circuit [160, 418] associated tap while outputting a tripping signal, said high impedance fault isolator [300] including a fire door sensor [174, 474] coupled to a grounded spring [309, 409], wherein said fire door sensor melts [174, 474] upon receipt of said tripping signal causing said spring [309, 409] to direct said live wire down fault to neutral earth ground in de-energizing the associated tap.

2. The arrangement [200] of claim 1, wherein:
said low or no voltage signal output includes coded data indicating the vicinity in a given tap of a live wire down fault, and
said high impedance fault isolator [300] in each tap includes in combination a microprocessor [301, 426] and a software chip [303, 428] storing unique location data for each of said feeder taps.

3. The arrangement of claim 2, wherein each of said slave smart meters [204a, 204b] is in communication with an associated father smart meter [204d] in a tap by means of a local area network (LAN).

4. The arrangement [200] of claim 1, wherein said high impedance fault isolator [300] includes over voltage protection such as in the form of surge protectors [330, 332, 430A, 430B].

5. The arrangement [200] of claim 1, wherein:
said tripping circuit [160, 418] further includes a local high voltage isolation device [334] coupled to said grounded spring [309a] and including a high voltage expulsion fuse, and
said expulsion fuse includes a tensioned fused link [182] disposed within a pivoting cylindrical fuse holder [184], wherein said fuse holder [184] is released upon contact with said grounded spring [309a] from an elevated position and falls under the influence of gravity to a lower position, wherein said fuse link [182] is grounded and deenergizes the associated tap.

6. The arrangement [200] of claim 1, wherein said high impedance fault isolator [300] further includes a local high voltage isolation device coupled to said spring and incorporating a recloser [201].

7. The arrangement [200] of claim 1, wherein said low voltage signal output is provided from said slave smart meters [204a, 204b] to a father smart meter [204d] in a given tap via an RF lead or a telephone line.

8. The arrangement of claim 1, wherein said tripping circuit [160, 418] includes a stainless steel or non-metallic holder [321] connected to said spring [309] for maintaining said spring [309] in a first ungrounded fixed position during normal operation, and with detection of a tripping signal said stainless steel or non-metallic holder [321] releases said spring [309] to contact with said local high voltage isolation device so as to deenergize a faulted live wire down.

9. The arrangement of claim 1, wherein the slave smart meters in each tap are coupled to a primary wire [203] in their associated tap by means of a serial coupled combination of a transformer [204] and a fuse [204a], and wherein said transformer forwards a loss of voltage RF signal to said father smart meter [204d].

10. The arrangement of claim 1, wherein each father smart meter [204d] services multiple slave smart meters [204a, 204b] via multiple transformers on a tap, and wherein each smart meter has the same phase as its associated smart meters such that two smart meters [204a, 204b] can simultaneously provide respective RF loss of voltage signals to said father smart [204d] meter confirming the detection of the primary wire down [203] by a second smart meter [204] in said tap.

11. A circuit for detecting, isolating and de-energizing a downed conductor in an electric utility distribution network, said circuit comprising:
a digital signal processor [301, 426] responsive to a fault signal representing a downed wire in said circuit;
a fire door sensor [174, 474] coupled to said digital signal processor [301, 426] and responsive to said fault signal, wherein said fire door sensor melts [174,474] in response to receipt of said fault signal;
a fixed support member coupled to said fire door sensor [174, 474]; and
a conductive spring [309, 409] coupled to and temporarily supported in a first position by said fixed support member, wherein melting of said fire door sensor [174, 474] causes said fixed support member to release said conductive spring [309, 409] to allow said conductive spring [309, 409] to apply solidly grounded position for de-energizing the downed conductor.

12. The circuit of claim 11, wherein said digital signal processor [301, 426] includes the combination of a microprocessor [301, 426] and a software chip [303, 428] storing data representing the location of a downed conductor.

13. The circuit of claim 11, wherein said fault signal is an in service or out of service signal in said electric utility distribution network.

14. The circuit of claim 11, wherein said fault signal includes coded RF signal data including system voltage status to said microprocessor [301, 426] in the electric utility distribution tap of the downed conductor, and
wherein said software chip [303, 428] stores the coded data indicating the location in the electric utility distribution network of the downed conductor.

15. The circuit of claim 11, wherein plural of said circuits are disposed in an electric utility distribution network in a spaced manner, and wherein said circuit further includes over voltage protection such as in the form of surge protectors [330, 332, 430A, 430B].
